(19)

Europäisches
Patentamt

European
Patent Office

Office européen
des brevets

(11)  **EP 2 156 374 B1**

(12)  **EUROPEAN PATENT SPECIFICATION**

(45) Date of publication and mention
of the grant of the patent:
**05.10.2011  Bulletin 2011/40**

(21) Application number: **08758315.9**

(22) Date of filing: **09.05.2008**

(51) Int Cl.:
***G06K 19/00*** *(2006.01)*

(86) International application number:
**PCT/EE2008/000011**

(87) International publication number:
**WO 2008/138355 (20.11.2008 Gazette 2008/47)**

(54) **A METHOD FOR MANUFACTURING OF A SMART PACKAGING MATERIAL**

VERFAHREN ZUR HERSTELLUNG EINES INTELLIGENTEN VERPACKUNGSMATERIALS

PROCÉDÉ DE FABRICATION DE MATÉRIAUX D'EMBALLAGES INTELLIGENTS

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority:  **11.05.2007  US 917541 P**

(43) Date of publication of application:
**24.02.2010  Bulletin 2010/08**

(73) Proprietor: **Raidenil Ltd.**
**51014 Tartu (EE)**

(72) Inventors:
 • **KARELSON, Mati**
   **51014 Tartu (EE)**

 • **KARELSON, Kaupo**
   **51014 Tartu (EE)**
 • **LEIS, Jaan**
   **51014 Tartu (EE)**
 • **SELI, Neinar**
   **51014 Tartu (EE)**

(74) Representative: **Sarap, Margus**
**Sarap & Partners Patent Agency**
**Riia 185A**
**51014 Tartu (EE)**

(56) References cited:
**US-A- 5 175 499**

## Description

FIELD OF THE INVENTION

This invention relates in general to the field of smart packaging materials. More specifically, this invention relates to a manufacturing method of low-cost plastic for packaging materials embedding tags possessing the magnetic activity.

BACKGROUND OF THE INVENTION

Smart and intelligent packaging materials and numerous methods for preparing such materials are well known for controlling and also giving information about the atmospheric and different physical and chemical conditions inside of package mainly in food and pharmaceutical industry [N. de Kruijf, M. van Beest, R. Rijk, T. Sipiläinen-Malm, P. Paseiro Losada, B. De Meulenaer, Active and intelligent packaging: applications and regulatory aspects, Food Additives and Contaminants ,19, Supplement, 144-162 (2002); K.L. Yam, P.T. Takhistov, J. Miltz, Intelligent Packaging: Concepts and Applications, J. Food. Sci., 70, R1-R10 (2005).; A. LaCoste, K.M. Schaich, D. Zumbrunnen, K.L.Yam, Advancing Controlled Release Packaging through Smart Blending, Packag. Technol. Sci., 18, 77-87 (2005).]. However, no packaging materials in situ carrying the hidden but magnetically detectable information about the content of package are known in the art.

In principle, a substrate which supports a material that generates an identifiable signal as a result of nuclear magnetic resonance, nuclear quadrupole, electron spin resonance, electron paramagnetic resonance, ferromagnetic resonance, ferromagnetic resonance, antiferromagnetic resonance, domain wall resonance or spin wave resonance or spin-echoes can be applied as the object marker. In such system, a microwave or radio frequency source emits electromagnetic radiation which is absorbed by the resonant material which in turn reemits electromagnetic radiation having a specific and readily detectable frequency signature [D.G. Davies, Systems and markers using magnetic or spin resonance phenomena, United States Patent 5,175,499 (December 29, 1992).]. Due to the sensitivity and robustness, electronic paramagnetic resonance (EPR) would be preferable solution in such systems. [D. Jerome, et al., Method of authenticating an object by electron paramagnetic resonance, apparatus for implementing the method, and an object useable with the method, United States Patent 5,149,946, (September 22, 1992).].

The radical cation salts derived from certain condensed polyaromatic hydrocarbons, such as naphthalene, fluoranthene and perylene have remarkably narrow electron spin resonance lines [L. Eberson, M.P. Hartshorn, O. Persson, Formation and EPR spectral detection of methyl-substituted naphthalene radical cations and products of their further transformations: binaphthalene formation, J. Chem. Soc. Perkin Trans. 2, 409-416 (1995); A. Wolter, U. Fasol, R. Jäppelt, and E. Dormann, Perylene radical cation salts with a five-eighths-filled conduction band: An ESR analysis, Phys. Rev, B 54, 12272-12282 (1996), C. Elschenbroich, R. Mockel, A. Vasil'kov, et al. Metal pi complexes of benzene derivatives, 52 - Chromium sandwich complexes of polycyclic aromatic hydrocarbons: Triphenylene and fluoranthene as eta(6) ligands, Eur. J. Inorg. Chem. 1391-1401 (1998).] However, they have inadequate thermal stability in time, being stable at low temperatures (about - 40 °C). To remedy this deficiency, thermally more stable polyalkyl perylenes have been proposed for the realization of ESR magnetic probes [P. Michel, et al. Process for preparing polyalkyl perylenes, perylenes obtained by this process, and organic materials with ESR properties derived from the same, United States Patent 4,956,508 (September 11, 1990).; P. Penven, et al., Organic material with extremely narrow electron spin resonance line and gaussmeter probe or magnetometer using this material, United States Patent 5,070,214 (December 3, 1991).]. However, being salts and easily soluble in different media including aqueous solutions, these compounds are not suitable as the minuscule additives to plastics.

The problem of instability at higher temperatures is also prohibitive for using most nitrogen-centered free radicals in EPR-sensitive tagging [M. Nakatsuji, Y. Miura, Y. Teki, EPR studies of nitrogen-centred free radicals. Part 53. Isolation, EPR spectra and magnetic characterization of N-(arylthio)-2,4-diaryl-6-cyanophenylaminyls, J. Chem. Soc. Perkin Trans. 2, 738-744, (2001).]. The highest stability has been observed in the case of N-alkoxyarylaminyl radicals [Y. Miura, T. Tomimura, N. Matsuba, R. Tanaka, M. Nakatsuji, Y. Teki, First isolation of monomeric N-alkoxyarylaminyl radicals and their chemical and magnetic properties, J. Org. Chem. 66, 7456-7463 (2001).]. However, the magnetic susceptibility measurements of these radicals showed either weak ferromagnetic interaction or weak antiferromagnetic interactions. Those weak magnetic interactions were attributed to the presence of bulky tert-butyl groups. Accordingly, the weak signals in the case of these radicals are hindering their practical use.

As one possible solution, multilayer EPR-active substrates have been proposed. Such programmable tags for being readable remotely and in a manner which does not require that the tag be held in a particular orientation, include a first layer of material with electron spin resonance absorption, a second layer of hard magnetic material, and a third layer of soft permeable magnetic material. [M.J. Brady, et al., Encodable tag with radio frequency readout, United States Patent 5,554,974 (September 10, 1996).]. More recently, this direction has been further developed with invention of organic integrated circuits (integrated plastic circuit), particularly related to a memory for RFID-tags: radio frequency identification tags [A. Bernds, et al., Method of writing to an organic memory, United States Patent 6,903,958 (June 7, 2005) and references therein; W. Clements, et al., Electronic component comprising predominantly organic functional materials and a method for the production thereof, United States Patent Application 20060024947 (February 2, 2006).]. However, in most these embodiments, the multilayer (multicomponent) plastic constructs are prohibitively expensive to have a mass usage.

In fact, organic radio-frequency identification tags (ORFID) are well known. However, these tags use complicated design, integrated electrical circuits and antennas for storing and transmitting the information [A. Bernds, et al., Organic memory, identification marker (RFID-tag) with organic memory and uses of an organic memory United States Patent Application 20040026690 (February 12, 2004); V. Subramanian, et al, Progress toward development of all-printed RFID tags: Materials, processes, and devices, PROCEEDINGS OF THE IEEE 93, 1330-1338 (2005).; M. Chason, et al., Printed organic semiconducting devices, PROCEEDINGS OF THE IEEE 93, 1348-1356 (2005); R. Parashkov, et al., Large area electronics using printing, methods, PROCEEDINGS OF THE IEEE 93,1321-1329 (2005).]. In fact, no identification tags using the magnetic properties of chemical compounds acting as the signal receivers, information storages and antennas and used as simple additives in bulk materials are known in the art.

SUMMARY OF THE INVENTION

The present invention describes the manufacturing method of low-cost plastic for packaging materials embedding tags possessing the magnetic activity. The latter consist of certain specifically selected polymeric additives homogeneously distributed in plastic material. A novel method gives the opportunity to assign the unique "magnetic fingerprint" to the plastic packaging or tagging item by controlling the chemical composition and concentration of polymeric additive.

In summary, an object of the present invention is to provide the economically beneficial manufacturing method of low-cost plastic materials for packaging and tags, which in situ carry the unique information about the package or tagged item.

Another object of the invention is the plastic material possessing the magnetic activity due to the certain specially selected polymeric additives homogeneously distributed in this plastic material.

In particular, the present invention provides the method to manufacture smart plastics by adding to the bulk plastic material the oligomeric or polymeric organic substance or substances, which have ferromagnetic properties and therefore can be detected by e.g. electron paramagnetic resonance detectors.

Another object of this invention is that the magnetically active polymeric compound is chosen so that it can be chemically modified by different substituents (R) whereas maintaining the ferromagnetic properties of the compound. It is thus possible to produce the variability of homologous compounds, but possessing the different magnetic activity.

The invention is defined by the independent claims.
Preferred embodiments are set out in the dependent claims.

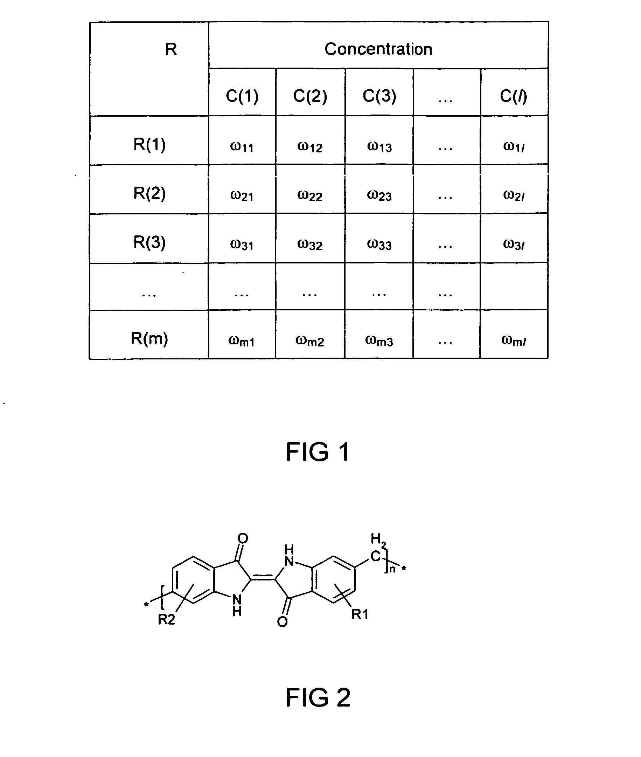

Effect of concentration (C) of magnetically active additive is reflected in the intensity of signal transmitted to the detector. Considering the fact that each substituent (R) causes the different wavelength of the transmitted signal and the variable concentration determines the strength of the signal, it is thus possible by controlling the chemical nature and content of the magnetically active component to create the following matrix of possible combinations (FIG 1).

The number of possible combinations of signal codes taken for each compound with different substituent (m compounds) at I different concentrations

$$C_l^m = l^m$$

In the special case of 10 compounds with different substituents (m = 10) and 10 different concentrations or signal strengths (l = 10), the number of possible different coding tags is

$$C_{10}^{10} = 10^{10} = 10,000,000,000$$

This number is large enough to accommodate all different tagging needs for the packaging of goods. Naturally, the increase of the number of differently substituted compounds or the sensitivity of the reading (more concentrations) rapidly increases this number.

BRIEF DESCRIPTION OF THE DRAWINGS

FIG 1 shows an example of the matrix of signal codes $\omega_{ij}$ from possible combinations of different substituents R(i) and concentrations C(j) of the respective compounds.

FIG 2 shows a chemical structure of poly-di-indolones.

FIG 3 shows a scheme of synthesis of substituted poly-di-indolones.

EXPERIMENTAL

Synthesis of magnetically active poly-di-indolones

Poly-di-indolones were chosen as a suitable set of EPR-active compounds to demonstrate the applicability of the present invention. These compounds possess high thermal and chemical stability, and have distinct sharp signals in the EPR spectra, which positions can be controlled by using the appropriate substituents at the ring (cf. FIG 2).

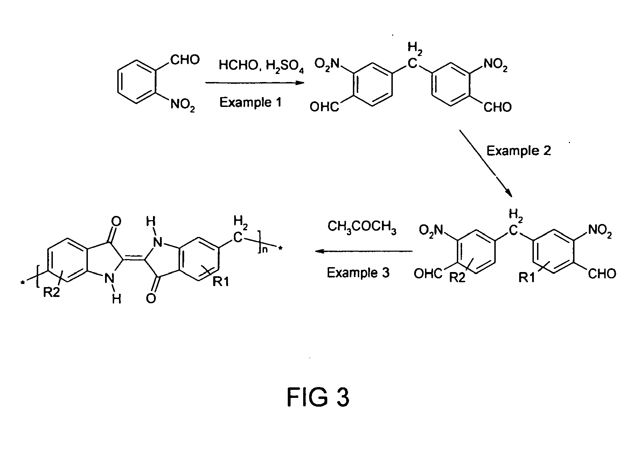

The following examples 1-3 (cf. FIG 3) describe the preparation of magnetically active poly-di-indolones, indigo type polymeric compounds by using the method previously described by Boscornea et al. [C. Boscornea, C.T. Mihaila, T. Tomas, C. Daescu, Synthesis and characterisation of some indigo type polymers having magnet properties. Revista de Chimie 2004, 55 (9), 730-733].

Example 1

o-Nitro-benzaldehyde (3 g) was added to solution of 4 ml of 37% formaldehyde, 60 ml $H_2O$ and 4 ml concentrated HCl placed in round bottom flask provided with a reflux condenser. The mixture was heated at 80 °C for 6 h. After that the reaction mixture was poured over crushed ice then the precipitate was filtered and dried. The yield of greenish-yellow solid product was 2,75 g.

Example 2

Bromine (0,3ml) was added drop-wise to the stirred solution of the product of example 1 (0,3g) dissolved in 10 ml of ethyl acetate placed in round bottom flask. After that the mixture was stirred for 3 h at room temperature. Then the mixture was poured over crushed ice. The product was extracted with ethyl acetate, the extracts were collected, and the solvent was evaporated to yield 0,2 g of solid product.

Example 3-1

Acetone (10 ml) was placed in flask and product of the example 1 (2 g) was added. To the stirred acetone-solution was during 30 min drop-wise added NaOH solution (7%, 22ml) while maintaining the temperature at 15-20 °C. The reaction mixture was left for 20 hours at room temperature, after that the precipitate was filtered and washed with acetone and water. After drying the yield of product was 1,9 g.

Example 3-2

Acetone (3 ml) was placed in flask and product of the example 2 (0,19) was added. To the stirred acetone-solution was during 20 min drop-wise added NaOH solution (4%, 5ml) while maintaining the temperature at 15-20 °C. The reaction mixture was left for 20 hours at room temperature, after that the precipitate was filtered and washed with acetone and water. After drying the wield of product was 40 mg.

EPR EXPERIMENTS

Electron paramagnetic resonance of various polymers were studied at temperatures 300 and 77 K. An X-band spectrometer operating at 9,17 GHz with magnetic field modulation frequency of 975 kHz was applied. The peak-to-peak line width, the peak-to-peak line intensity and the g- value of EPR resonances were determined. F+ centers in plastically deformed CaS polycrystrals (g(F+)= 2,0031 at 300K) and Cr3+ centres in MgO crystals (g(Cr3+)= 1,9798 at 300K) were used for calibration. A pulse step annealing with the pulse duration of 10 minutes was applied for investigation of the thermal stability of paramagnetic particles.

One single line with the g value 2,004 and width 13,0 G was observed at 300K in polyaniline taken as the standard. This line was not found in the case of other polymers. An isotropic line with the g value 2,0052 and width 9,0 G (T= 300K) is characteristic for these compounds (polyaniline does not belong to the group). The intensity variations (in arbitrary units) of the line for various polymers are given below:

| Polymer | T= 300K | T= 77K |
|---|---|---|
| "K" | 20,7 | 20,7 |
| "delta" | 36,7 | 36,7 |
| "P(D-1-Br)" | 30,2 | 22,0 |
| "P(D-1)Br-1" | 26,8 | 17,4 |

The intensity weakly alters from polymer to polymer as well as with the temperature of the samples. An entirely different behaviour was observed for the line with g=2,004 in polyaniline, where the line intensity increased 2,4 times as the temperature decreased from 300K to 77K.

The particles with g= 2,0052 decay (in polymer "K") at the temperature interval 80-180 °C. A new intense isotropic line with g= 2,0030 and the width 6,3G forms at the 180 to 360 °C (and probably at higher temperature). Decay of the polymer can provide an explanation for these processes.

The remarkable narrowness of these electron spin resonance lines should enable these materials to be used for realizing highly sensitive magnetometers.

According to the method for manufacturing of a smart packaging material are used the combination of different magnetically active organic compounds or organic polymers at different concentrations which are melted into the polymeric packaging material. The polymeric packaging material is possibly chosen from the polyethylene, polypropylene, polybutene-1, polystyrene, polyamide, polymethylmethacrylate, polyvinylchloride, polydimethyl siloxane, polyoxymethylene, polycarbonate, polyethylene terephthalate, polyetheretherketone, Nylon 6, polyamideimide, polysulphone, polyphenylene sulphide, polyethersulphone, polyetherimide, polytetrafluoroethylene.

The active organic compounds or organic polymers are emitting the response signal to external magnetic field at different frequencies whereas the magnetically active organic compounds according to the invention are differently substituted radical cation salts of formula (Ar)2+X-, in which Ar represents an aromatic hydrocarbon such as naphthalene, fluoranthene or perylene and X- an-anion; substituted radical cations of heterocyclics such as 1,1-bis-(p-cyanophenyl)-4,4-bipyridiliums or radical ions of dithiadiazafulvalenes, tetrathiafulvalene derivatives, pyrazinophanes, 1,4-diphosphoniacyclohexa-2,5-diene derivatives or triphenodithiazines, which have an adequate electron magnetic moment to be used in magnetometer probes.

In another embodiment of the present invention the magnetically active organic polymers are radical cations of differently substituted polyparaphenylene vinylenes, polypyrroles, polyanilines, polyparaphenylene sulfides, polythiophenes, polyselenophenes, polyfurans, polyacetylenes, polydithienopyridines, polydithienothiophenes, poly(3,4-ethylenedioxythiophene)s, or differently substituted poly-di-indolones, which have an adequate electron magnetic moment to be used in magnetometer probes.

According to the present invention the number of the different organic compounds or organic polymers which are used for manufacturing packaging material is not limited but preferably the number of said different organic compounds and organic polymers is between 10 and 20.

Also according to the present invention the number of different concentrations of magnetically active compounds or polymers which are used for manufacturing packaging material is not limited but preferably the concentration of said different magnetically active compounds or polymers is between 10 and 50.

REFERENCES CITED

U.S. Patent Documents

1. A. Bernds, et al., Method of writing to an organic memory, United States Patent 6,903,958 (June 7, 2005).

2. A. Bernds, et al., Organic memory, identification marker (rfid-tag) with organic memory and uses of an organic memory, United States Patent Application 20040026690 (February 12, 2004).

3. M.J. Brady, et al., Encodable tag with radio frequency readout, United States Patent 5,554,974 (September 10, 1996).

4. W. Clements, et al., Electronic component comprising predominantly organic functional materials and a method for the production thereof, United States Patent Application 20060024947 (February 2, 2006).

5. D.G. Davies, Systems and markers using magnetic or spin resonance phenomena, United States Patent 5,175,499 (December 29, 1992).

6. D. Jerome, et al., Method of authenticating an object by electron paramagnetic resonance, apparatus for implementing the method, and an object useable with the method, United States Patent 5,149,946, (September 22, 1992).

7. P. Michel, et al. Process for preparing polyalkyl perylenes, perylenes obtained by this process, and organic materials with ESR properties derived from the same, United States Patent 4,956,508 (September 11, 1990).

8. P. Penven, et al., Organic material with extremely narrow electron spin resonance line and gaussmeter probe or magnetometer using this material, United States Patent 5,070,214 (December 3, 1991).

Other References

1. C. Boscornea, C.T. Mihaila, T. Tomas, C. Daescu, Synthesis and characterisation of some indigo type polymers having magnet properties. Revista de Chimie, 55, 730-733 (2004).

2. M. Chason, et al., Printed organic semiconducting devices, PROCEEDINGS OF THE IEEE 93, 1348-1356 (2005).

3. L. Eberson, M.P. Hartshorn, O. Persson, Formation and EPR spectral detection of methyl-substituted naphthalene radical cations and products of their further transformations: binaphthalene formation, J. Chem. Soc. Perkin Trans. 2, 409-416 (1995).

4. C. Elschenbroich, R. Mockel, A. Vasil'kov, et al. Metal pi complexes of benzene derivatives, 52 - Chromium sandwich complexes of polycyclic aromatic hydrocarbons: Triphenylene and fluoranthene as eta(6) ligands, Eur. J. Inorg. Chem. 1391-1401 (1998).

5. N. de Kruijf. M. van Beest, R. Rijk, T. Sipiläinen-Malm, P. Paseiro Losada, B. De Meulenaer, Active and intelligent packaging: applications and regulatory aspects, Food Additives and Contaminants ,19, Supplement, 144-162 (2002).

6. A. LaCoste, K.M. Schaich, D. Zumbrunnen, K.L.Yam, Advancing Controlled Release Packaging through Smart Blending, Packag. Technol. Sci., 18, 77-87 (2005).

7. Y. Miura, T. Tomimura, N. Matsuba, R. Tanaka, M. Nakatsuji, Y. Teki, First isolation of monomeric N-alkoxyarylaminyl radicals and their chemical and magnetic properties, J. Org. Chem. 66, 7456-7463 (2001).

8. M. Nakatsuji, Y. Miura, Y. Teki, EPR studies of nitrogen-centred free radicals. Part 53. Isolation, EPR spectra and magnetic characterization of N-(arylthio)-2,4-diaryl-6-cyanophenylaminyls, J. Chem. Soc. Perkin Trans. 2, 738-744, (2001).

9. R. Parashkov, et al., Large area electronics using printing, methods, PROCEEDINGS OF THE IEEE 93,1321-1329 (2005).

10. V. Subramanian, et al, Progress toward development of all-printed RFID tags: Materials, processes, and devices, PROCEEDINGS OF THE IEEE 93, 1330-1338 (2005).

11. A. Wolter, U. Fasol, R. Jäppelt, and E. Dormann, Perylene radical cation salts with a five-eighths-filled conduction band: An ESR analysis, Phys. Rev, B 54, 12272 - 12282 (1996).

12. K.L. Yam, P.T. Takhistov, J. Miltz, Intelligent Packaging: Concepts and Applications, J. Food. Sci., 70, R1-R10 (2005).

**Claims**

1. A method for manufacturing of a smart packaging material
   where for tagging of the smart packaging material a combination of different magnetically active organic compounds or magnetically active organic polymers at different concentrations is used
   **characterised in that**
   the combination of the different magnetically active organic compounds or magnetically active organic polymers is melted into a polymeric, packaging material,
   and wherein said magnetically active organic compounds or organic polymers emit a response signal at different frequencies to an external magnetic field.

2. The method according to claim 1 **characterised in that** any number of different magnetically active organic compounds or magnetically active organic polymers are used for manufacturing smart packaging material.

3. The method according to claim 2 **characterised in that** the number of magnetically active organic compounds or magnetically active organic polymers is between 10 and 20.

4. The method according to claim 1 **characterised in that** any number of different concentrations of magnetically active organic compounds or magnetically active organic polymers are used for manufacturing smart packaging material.

5. The method according to claim 4 **characterised in that** the concentration of magnetically active organic compounds or magnetically active organic polymers is between 10 and 20.

6. The method according to claim 1 **characterised in that** the magnetically active organic compounds are differently substituted radical cation salts of formula (Ar)2+X-, in which Ar represents an aromatic hydrocarbon such as naphthalene, fluoranthene or perylene and X-an-anion; substituted radical cations of heterocyclics such as 1,1-bis-(p-cyanophenyl)-4,4-bipyridiliums or radical ions of dithiadiazafulvalenes, tetrathiafulvalene derivatives, pyrazinophanes, 1,4-diphosphoniacyclohexa-2,5-diene derivatives or triphenodithiazines, which have an adequate electron magnetic moment to be used in magnetometer probes.

7. The method according to claim 1 **characterised in that** the magnetically active organic polymers are radical cations of differently substituted polyparaphenylene vinylenes, polypyrroles, polyanilines, polyparaphenylene sulfides, poly-thiophenes, polyselenophenes, polyfurans, polyacetylenes, polydithieno-pyridines, polydithienothiophenes, poly(3,4-ethylenedioxythiophene)s, or differently substituted poly-di-indolones, which have an adequate electron magnetic moment to be used in magnetometer probes.

8. The method according to claim 1 **characterised in that** the polymeric packaging material is polyethylene, polypropylene, polybutene-1, polystyrene, polyamide, polymethylmethacrylate, polyvinylchloride, polydimethyl siloxane, polyoxymethylene, polycarbonate, polyethylene terephthalate, polyetheretherketone, Nylon 6, polyamideimide, polysulphone, polyphenylene sulphide, polyethersulphone, polyetherimide, polytetrafluoroethylene.

9. A smart packaging material manufactured according to the method of the claims 1-6
   **characterised in that**
   said smart packaging material comprises said polymeric packaging material and the different magnetically active organic compounds or magnetically active organic polymers at different concentrations melted into the polymeric packaging material for tagging said smart packaging material whereby said active organic compounds or organic polymers are adapted to emit a response signal at different frequencies to an external magnetic field.

10. The smart packaging material according to claim 9 **characterised in that** said smart packaging material comprises preferably 10 to 20 different magnetically active organic compounds or magnetically active organic polymers.

11. The smart packaging material according to the claim 9 **characterised in that** the concentration of the different magnetically active organic compounds or magnetically active organic polymers in said smart packaging material is between 10 and 50.

12. The smart packaging material according to claim 9 **characterised in that** the magnetically active organic polymers are radical cations of differently substituted polyparaphenylene vinylenes, polypyrroles, polyanilines, polyparaphenylene sulfides, polythiophenes, polyselenophenes, polyfurans, polyacetylenes, polydithienopyridines, polydithienothiophenes, poly(3,4-ethylenedioxythio-phene)s, or differently substituted poly-di-indolones, which have an adequate electron magnetic moment to be used in magnetometer probes.

13. The smart packaging material according to claim 9 **characterised in that** the polymeric packaging material is polyethylene, polypropylene, polybutene-1, polystyrene, polyamide, polymethylmethacrylate, polyvinylchloride, polydimethyl siloxane, polyoxymethylene, polycarbonate, polyethylene terephthalate, polyetherether-ketone, Nylon 6, polyamide-imide, polysulphone, polyphenylene sulphide, polyethersulphone, polyetherimide or polytetrafluoroethylene.

**Patentansprüche**

1. Verfahren zur Herstellung eines intelligenten Verpackungsmaterials wobei für die Kennzeichnung des intelligenten Verpackungsmaterials die Kombination unterschiedlicher magnetisch aktiver organischer Verbindungen oder magentisch aktiver organischer Polymere mit unterschiedlichen Konzentrationen eingesetzt wird
**gekennzeichnet dadurch, dass**
die Kombination der verschiedenen magnetisch aktiven organischen Verbindungen oder magnetisch aktiven organischen Polymeren die in einem polymeren Verpakkungsmaterial eingeschmolzen werden,
und worin besagte magnetisch aktive organische Verbindungen oder organische Polymere bei verschiedenen Frequenzen ein Reaktionssignal zu einem externen magnetischem Feld ausstrahlen.

2. Verfahren nach Anspruch 1 **dadurch gekennzeichnet, dass** eine frei zu bestimmende Anzahl an unterschiedlichen magnetisch aktiven organischen Verbindungen oder magnetisch aktiven organischen Polymere in der Herstellung des intelligenten Verpackungsmaterials eingesetzt werden.

3. Verfahren nach Anspruch 2 **dadurch gekennzeichnet, dass** die Anzahl der magnetisch aktiven organischen Verbindungen oder magentisch aktiven organischen Polymere zwischen 10 und 20 liegt.

4. Verfahren nach Anspruch 1 **dadurch gekennzeichnet, dass** die Anzahl der unterschiedlichen Konzentrationen der magnetisch aktiven organischen Verbindungen oder magnetisch aktiven organischen Polymere in der Herstellung des intelligenten Verpackungsmaterials frei zu bestimmen sind.

5. Verfahren nach Anspruch 4 **dadurch gekennzeichnet, dass** die Anzahl der unterschiedlichen Konzentrationen der magnetisch aktiven organischen Verbindungen oder magnetisch aktiven organischen Polymere zwischen 10 und 20 liegt.

6. Verfahren nach Anspruch **gekennzeichnet dadurch, dass** die magnetisch aktiven organischen Verbindungen aus unterschiedlichen radikalen Kation salzen mit der Formel $(Ar)_2^+X^-$ bestehen, wobei Ar einen aromatischen Kohlenwasserstoff wie z.B. Naphthalin, Fluoranthen oder Perylen repräsentiert und das $X^-$ ein Anion; substituierte radikale Kationen der Heterozyklen wie z.B. 1,1-bis-(p-cyanophenyl)-4,4-bipyridiliums oder radikale Ionen von Dithiadiazafulvalen, Tetrathiafulvalenderivate, Pyrazinophan, 1,4-diphosphoniacyclohexa-2,5-diene-Derivate oder Triphenodithiazine, die ein adäquates magnetisches Elektronenmoment für den Einsatz in Magnetometersonden besitzen.

7. Verfahren nach Anspruch 1 **gekennzeichnet durch** das Bestehen der magnetisch aktiven organischen Polymeren in Form von radikalen Kationen unterschiedlicher substituierter Polyparaphenylenvinyle, Polypyrole, Polyaniline, Polyparaphenylensulfide, Polythiophene, Polyselenophene, Polyfurane, Polyacetylene, Polydithienopyridine, Polydithienothiophene, Poly(3,4-Ethylendioxythiophene), oder unterschiedlich substituierte Polydiindolone, die einen adäquates magnetisches Elektronenmoment für den Einsatz in Magnetometersonden besitzen.

8. Verfahren nach Anspruch 1 **gekennzeichnet dadurch, dass** das polymere Verpackungsmaterial aus den Polymeren Polyethylen, Polypropylen, Polybuten-1, Polystyren, Polyamid, Polymethylmethacrylat, Polyvinylchlor, Polydimethylsiloxan, Polyoxymethylen, Polykarbonat, Polyethylenterephthalat, Polyetheretherketon, Nylon 6, Polyamidimid, Polysulfon, Polyphenylensulfid, Polyethersulfon, Polyetherimid, Polytetrafluoroethylen besteht.

9. Ein intelligentes Verpackungsmaterial hergestellt entsprechend des Verfahrens beschrieben in Ansprüche 1 bis 6 **gekennzeichnet dadurch, dass** das besagte intelligente Verpackungsmaterial das besagte polymere Verpackungsmaterial und die mit unterschiedlichen Konzentrationen, im Polymer eingeschmolzenen, verschiedenen magnetisch aktiven organischen Verbindungen oder magnetisch aktiven organischen Polymeren zur Bezeichnung des besagten intelligenten Verpackungsmaterials beinhaltet, wobei die besagten aktiven organischen Verbindungen oder organischen Polymere für die Ausstrahlung eines Reaktionssignals zu einem externen magnetischem Feld bei unterschiedlichen Frequenzen adaptiert sind.

10. Das intelligente Verpackungsmaterial nach Anspruch 9 **gekennzeichnet dadurch, dass** das besagte intelligente Verpackungsmaterial 10 bis 20 unterschiedliche magnetisch aktive organische Verbindungen oder magnetisch aktive organische Polymere enthält.

11. Das intelligente Verpackungsmaterial nach Anspruch 9 **gekennzeichnet durch** eine Anzahl der unterschiedlichen Konzentrationen der verschiedenen magnetisch aktiven organischen Verbindungen oder magnetisch aktiven organischen Polymere im besagten intelligenten Material zwischen 10 und 50.

12. Das intelligente Verpackungsmaterial nach Anspruch 9 **gekennzeichnet durch** das Bestehen der magnetisch aktiven organischen Polymere in Form von radikalen Kationen unterschiedlich substituierter Polyparaphenylenvinyle, Polypyrole, Polyaniline, Polyparaphenylsulfide, Polythiophene, Polyselenophene, Polyfurane, Polyacetylene, Polydithienopyridine, Polydithienothiophene, Poly(3,4-Ethylenedioxythiophene), oder unterschiedlich substituierte Polydiindolone, die einen adäquates magnetisches Elektronenmoment für den Einsatz in Magnetometersonden besitzen.

13. Das intelligente Verpackungsmaterial nach Anspruch 9 **gekennzeichnet dadurch, dass** das polymere Verpackungsmaterial aus den Polymeren Polyethylen, Polypropylen, Polybuten-1, Polystyren, Polyamid, Polymethylmethacrylat, Polyvinylchlor, Polydimethylsiloxan, Polyoxymethylen, Polykarbonat, Polyethylenterephthalat, Polyetheretherketon, Nylon 6, Polyamidimide, Polysulfon, Polyphenylensulfid, Polyethersulfon, Polyetherimid, Polytetrafluoroethylen besteht.

**Revendications**

1. Un procédé de fabrication d'un matériau d'emballage à puce où pour le marquage des matériaux d'emballage à puce la combinaison de différents composés organiques magnétiquement actifs ou des polymères organiques magnétiquement actifs à des concentrations différentes est utilisée
   **caractérisé en ce que**
   la combinaison des différents composés organiques magnétiquement actifs ou des polymères organiques magnétiquement actifs est fondu dans un matériau d'emballage polymérique,
   et lesdit composés organiques magnétiquement actifs ou polymères organiques émettent un signal de réponse à des fréquences différentes pour un champ magnétique externe.

2. La méthode selon la revendication 1 **caractérisée par le fait que** tous nombres de différents composés organiques magnétiquement actifs ou polymères organiques magnétiquement actifs sont utilisés pour la fabrication de matériaux d'emballage à puce.

3. La méthode selon la revendication 2 **caractérisée par le fait que** le nombre de composés organiques magnétiquement actifs ou de polymères organiques magnétiquement actifs se situe entre 10 et 20.

4. La méthode selon la revendication 1 **caractérisée par** que le fait que tous nombres de différentes concentrations des composés organiques magnétiquement actifs ou polymères organiques magnétiquement actifs sont utilisés pour la fabrication de matériaux d'emballage à puce.

5. La méthode selon la revendication 4 **caractérisée par le fait que** la concentration des composés organiques magnétiquement actifs ou de polymères organiques magnétiquement actifs se situe entre 10 et 20.

6. La méthode selon la revendication 1 **caractérisée par le fait que** les composés organiques magnétiquement actifs sont des sels de cations radicaux différemment substitués de formule (Ar) 2 + X-, dans laquelle Ar représente un hydrocarbure aromatique tel que le naphtalène, fluoranthène ou pérylène et X-un anion; des cations radicaux des hétérocycles substitués tels que le 1,1-bis-(p-cyanophényl)-4,4-bipyridiliums ou ions radicaux de dithiadiazafulvalenes, tétrathiafulvalène dérivés, pyrazinophanes, 1,4-diphosphoniacyclohexa-2,5-diène dérivés ou triphenodithiazines, qui ont un instant magnétique d'électron adéquat pour être utilisés dans les sondes magnétomètres.

7. La méthode selon la revendication 1 **caractérisée par** que le fait que les polymères organiques magnétiquement actifs sont des cations radicaux du vinylènes polyparaphénylène différemment substitués, polypyrroles, polyanilines, sulfures polyparaphénylène, poly-thiophènes, polyselenophenes, polyfurans, poly acétylènes, polydithieno-pyridines, polydithienothiophenes, poly(3,4-éthylènedioxythiophène)s, ou poly-di-indolones différemment substitués, qui ont un instant magnétique d'électron adéquat pour être utilisés dans les sondes magnétomètres.

**8.** La méthode selon la revendication 1 **caractérisée par le fait que** le matériau d'emballage polymèrique est le polyéthylène, polypropylène, polybutène-1, polystyrène, polyamide, polyméthacrylate de méthyle, chlorure de polyvinyle, polydiméthylsiloxane, polyoxyméthylène, polycarbonate, polyéthylène téréphtalate, polyétheréthercétone, Nylon 6, polyamideimide, polysulfone, polysulfure de phénylène, polyéthersulfone, polyétherimide, polytétrafluoroéthylène.

**9.** Un matériau d'emballage à puce fabriqué selon la méthode des revendications 1-6 **caractérisé en ce que**

ledit matériau d'emballage à puce comprend ledit matériau d'emballage polymérique et les différents composés organiques magnétiquement actifs ou les polymères organiques magnétiquement actifs à des concentrations différentes fondus dans le matériau d'emballage polymérique pour le marquage des lesdits matériaux d'emballage à puce,

lesquels composés organiques actifs ou polymères organiques sont adaptés pour émettre un signal de réponse à des fréquences différentes pour un champ magnétique externe.

**10.** Le matériau d'emballage à puce selon la revendication 9 **caractérisée par le fait que** ledit matériau d'emballage à puce comprend de préférence 10 à 20 différents composés organiques magnétiquement actifs ou polymères organiques magnétiquement actifs.

**11.** Le matériau d'emballage à puce selon la revendication 9 **caractérisée par le fait que** la concentration des différents composés organiques magnétiquement actifs ou des polymères organiques magnétiquement actifs dans ledit matériau d'emballage à puce est entre 10 et 50.

**12.** Le matériau d'emballage à puce selon la revendication 9 **caractérisée par le fait que** les polymères organiques magnétiquement actifs sont des cations radicaux des vinylènes polyparaphénylène différemment substitués, polypyrroles, polyanilines, sulfures polyparaphénylène, polythiophènes, polyselenophenes, polyfurans, polyacétylènes, polydithienopyridines, polydithienothiophenes, poly (3,4-ethylenedioxythio-phène)s, ou poly-di-indolones différemment substitués, qui ont un moment magnétique d'électron adéquat pour être utilisé dans les sondes magnétomètres

**13.** Le matériau d'emballage à puce selon la revendication 9 **caractérisée par le fait que** le matériau d'emballage polymèrique est le polyéthylène, polypropylène, polybutène-1, polystyrène, polyamide, polyméthacrylate de méthyle, chlorure de polyvinyle, polydiméthylsiloxane, polyoxyméthylène, polycarbonate, polyéthylène téréphtalate, polyétheréther-cétone, nylon 6, polyamide-imide, polysulfone, polysulfure de phénylène, polyéthersulfone, polyétherimide ou polytétrafluoroéthylène

| R | Concentration | | | | |
|---|---|---|---|---|---|
| | C(1) | C(2) | C(3) | ... | C(_l_) |
| R(1) | $\omega_{11}$ | $\omega_{12}$ | $\omega_{13}$ | ... | $\omega_{1l}$ |
| R(2) | $\omega_{21}$ | $\omega_{22}$ | $\omega_{23}$ | ... | $\omega_{2l}$ |
| R(3) | $\omega_{31}$ | $\omega_{32}$ | $\omega_{33}$ | ... | $\omega_{3l}$ |
| ... | ... | ... | ... | ... | |
| R(m) | $\omega_{m1}$ | $\omega_{m2}$ | $\omega_{m3}$ | ... | $\omega_{ml}$ |

# FIG 1

# FIG 2

FIG 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5175499 A
- US 5149946 A
- US 4956508 A
- US 5070214 A
- US 5554974 A
- US 6903958 B
- US 20060024947 A
- US 20040026690 A

### Non-patent literature cited in the description

- **N. de Kruijf ; M. van Beest ; R. Rijk ; T. Sipiläinen-Malm ; P. Paseiro Losada ; B. De Meulenaer.** Active and intelligent packaging: applications and regulatory aspects. *Food Additives and Contaminants,* 2002, vol. 19 (144-162
- **K.L. Yam ; P.T. Takhistov ; J. Miltz.** Intelligent Packaging: Concepts and Applications. *J. Food. Sci.,* 2005, vol. 70, R1-R10
- **A. LaCoste ; K.M. Schaich ; D. Zumbrunnen ; K.L.Yam.** Advancing Controlled Release Packaging through Smart Blending. *Packag. Technol. Sci.,* 2005, vol. 18, 77-87
- **L. Eberson ; M.P. Hartshorn ; O. Persson.** Formation and EPR spectral detection of methyl-substituted naphthalene radical cations and products of their further transformations: binaphthalene formation. *J. Chem. Soc. Perkin Trans.,* 1995, vol. 2, 409-416
- **A. Wolter ; U. Fasol ; R. Jäppelt ; E. Dormann.** Perylene radical cation salts with a five-eighths-filled conduction band: An ESR analysis. *Phys. Rev, B,* 1996, vol. 54, 12272-12282
- **C. Elschenbroich ; R. Mockel ; A. Vasil'kov et al.** Metal pi complexes of benzene derivatives, 52 - Chromium sandwich complexes of polycyclic aromatic hydrocarbons: Triphenylene and fluoranthene as eta(6) ligands. *Eur. J. Inorg. Chem.,* 1998, 1391-1401
- **M. Nakatsuji ; Y. Miura ; Y. Teki.** EPR studies of nitrogen-centred free radicals. Part 53. Isolation, EPR spectra and magnetic characterization of N-(arylthio)-2,4-diaryl-6-cyanophenylaminyls. *J. Chem. Soc. Perkin Trans.,* 2001, vol. 2, 738-744
- **Y. Miura ; T. Tomimura ; N. Matsuba ; R. Tanaka ; M. Nakatsuji ; Y. Teki.** First isolation of monomeric N-alkoxyarylaminyl radicals and their chemical and magnetic properties. *J. Org. Chem.,* 2001, vol. 66, 7456-7463
- **V. Subramanian et al.** Progress toward development of all-printed RFID tags: Materials, processes, and devices. *PROCEEDINGS OF THE IEEE,* 2005, vol. 93, 1330-1338
- **M. Chason et al.** Printed organic semiconducting devices. *PROCEEDINGS OF THE IEEE,* 2005, vol. 93, 1348-1356
- **R. Parashkov et al.** Large area electronics using printing, methods. *PROCEEDINGS OF THE IEEE,* 2005, vol. 93, 1321-1329
- **C. Boscornea ; C.T. Mihaila ; T. Tomas ; C. Daescu.** Synthesis and characterisation of some indigo type polymers having magnet properties. *Revista de Chimie,* vol. 55 (9), 730-733
- **C. Boscornea ; C.T. Mihaila ; T. Tomas ; C. Daescu.** Synthesis and characterisation of some indigo type polymers having magnet properties. *Revista de Chimie,* 2004, vol. 55, 730-733
- **N. de Kruijf. ; M. van Beest ; R. Rijk ; T. Sipiläinen-Malm ; P. Paseiro Losada ; B. De Meulenaer.** Active and intelligent packaging: applications and regulatory aspects. *Food Additives and Contaminants,* 2002, vol. 19, 144-162
- **A. Wolter ; U. Fasol ; R. Jäppelt ; E. Dormann.** Perylene radical cation salts with a five-eighths-filled conduction band: An ESR analysis. *Phys. Rev, B,* 1996, vol. 54, 12272-12282